# FASCICULE DE BREVET EUROPEEN

(11) **EP 2 017 960 B1**
(45) Date de publication et mention de la délivrance du brevet: **30.12.2009**
(21) Numéro de dépôt: 07014189.0
(22) Date de dépôt: 19.07.2007
(51) Int. Cl.: H03H 9/215

(54) **Résonateur piézo-électrique ayant des capacités motionnelles optimisées**
Piezoelektrischer Resonator mit optimierten Bewegungsfähigkeiten
Piezoelectric resonator with optimised motional capacity

(43) Date de publication de la demande: 21.01.2009
(73) Titulaire: ETA SA Manufacture Horlogère Suisse, 2540 Grenchen (CH)
(72) Inventeur: Dalla Piazza, Silvio, 2610 St.-Imier (CH); Staub, Felix, 3425 Koppigen (CH); Studer, Bruno, 4533 Riedholz (CH)
(74) Mandataire: Ravenel, Thierry Gérard Louis

(56) Documents cités:
- EP-A- 1 633 042
- EP-A- 1 650 866
- JP-A- 2005 005 896

## Description

### DOMAINE DE L'INVENTION

La présente invention concerne des résonateurs piézo-électriques et plus particulièrement des résonateurs de petites dimensions qui sont le plus souvent utilisés pour la réalisation de générateurs de fréquences, en particulier pour des équipements électroniques portables utilisés dans divers domaines tels que l'horlogerie, l'informatique, les télécommunications et le domaine médical.

### ARRIERE PLAN DE L'INVENTION

Le document JP 2005005896 décrit un résonateur à diapason formé d'une base et de deux bras vibrants s'étendant à partir de la base. Des rainures sont prévues dans chaque bras. Chaque bras comprend également à son extrémité des palmes.

Des résonateurs de ce type ayant de petites dimensions ont déjà été décrits dans le document antérieur US 4,384,232. Ce document décrit un résonateur à diapason formé d'une base et de deux bras vibrants s'étendant à partir de la base. Chaque bras porte des métallisations qui forment des électrodes centrales sur les surfaces principales opposées et des électrodes latérales le long des côtés de chaque bras. Les électrodes centrales d'un bras sont connectées aux électrodes latérales de l'autre bras et à une borne d'une alimentation. Les autres électrodes centrales et latérales sont connectées de manière identique à l'autre borne de l'alimentation. Les électrodes sont soumises à des champs électriques afin de faire vibrer les bras à une fréquence fondamentale désirée.

Des rainures sont prévues dans chaque bras. La disposition des électrodes centrales à l'intérieur des rainures, dans l'épaisseur des bras, augmente le couplage piézo-électrique. A dimensions égales, cette augmentation du couplage entraîne une diminution de la résistance équivalente pour un facteur de qualité donné du résonateur et par conséquent une diminution de la consommation de ce dernier. Cet effet peut être modélisé comme résultant de la réduction de la résistance série représentant les pertes dans le circuit résonateur classique équivalent. Inversement, pour la même résistance équivalente recherchée, cette disposition permet une réduction des dimensions du résonateur.

Ces rainures sont avantageusement aussi profondes que possible sous restriction de permettre de conserver une bonne résistance mécanique du résonateur. Les zones disposées entre les rainures et les bords latéraux des bras doivent restés suffisamment rigides et doivent rester connectées à la partie centrale des bras de manière également suffisamment rigides afin de pouvoir faire vibrer la totalité du diapason.

Grâce à l'utilisation de telles rainures, il est possible d'atteindre un degré de miniaturisation plus élevé, pour une même fréquence et pour une même résistance équivalente données. Toutefois, au-dessous d'une certaine dimension, la diminution du volume de matériaux piézo-électrique élastiquement actif est associée à une diminution du facteur de qualité, ce qui engendre une augmentation non désirée de la résistance équivalente.

Un but de la présente invention est donc de fournir un résonateur piézo-électrique pouvant être miniaturisé le plus possible sans entraîner une augmentation excessive de la résistance équivalente.

En outre, un résonateur piézo-électrique du type décrit ci-dessus présente une certaine capacité motionnelle que l'on peut définir comme étant proportionnelle à l'intégrale des contraintes pour chaque mode de résonance, c'est-à-dire pour un mode de résonance de fréquence fondamentale, mais également pour les modes de résonance de fréquence harmoniques et plus particulièrement pour un premier mode de résonance de fréquence partielle. Un autre but de la présente invention est donc de fournir un résonateur pièzo-électrique ayant une capacité motionnelle maximum pour la fréquence fondamentale et une capacité motionnelle minimum pour la fréquence partielle, qui est celle qui peut être démarrée de manière accidentelle par le circuit oscillateur.

### RESUME DE L'INVENTION

La présente invention atteint les buts ci-dessus en fournissant un résonateur piézo-électrique à diapason conforme à la revendication 1 annexée.

On comprendra qu'un résonateur piézo-électrique à diapason du type correspondant au préambule de la revendication 1 possède notamment une première capacité motionnelle pour une première fréquence, dite fréquence fondamentale et une deuxième capacité motionnelle pour une deuxième fréquence, dite fréquence partielle. On comprendra de plus que les caractéristiques qui font l'objet de la présente invention permettent avantageusement d'augmenter ladite première capacité motionnelle du résonateur pour la fréquence fondamentale, et de diminuer ladite deuxième capacité motionnelle du résonateur pour la fréquence partielle. Elles permettent en outre d'assurer une meilleure distribution des contraintes mécaniques le long des bras vibrants et d'augmenter la résistance aux chocs.

En particulier, on comprendra que selon la présente invention, la répartition de la masse formant les bras vibrants diffère considérablement de l'art antérieur. En effet, la présente invention prévoit que les bras vibrants présentent une forme effilée et se terminent par un élargissement appelé palme. Un avantage de cette répartition de la masse est d'élever le plus possible le facteur de qualité. L'effet des palmes, en particulier, est de faire baisser la fréquence pour une longueur donnée des bras, et ainsi de permettre d'ajuster la fréquence à la valeur désirée.

Un autre avantage lié à la présence des palmes est de défavoriser la résonance en mode de fréquence partielle. En effet, les palmes ont pour effet de coupler ce dernier mode avec les modes de torsion autour de l'axe de symétrie du bras. Ce qui a pour effet de diminuer la capacité motionelle propre de ce mode.

La présence des rainures, quant à elle, entraîne une diminution de la résistance équivalente pour un facteur de qualité donné du résonateur. Toutefois, les rainures n'ont qu'un effet secondaire sur le facteur de qualité lui-même.

On comprendra de plus, que selon la présente invention, les rainures s'étendent le long des bras jusqu'au-delà du point d'élargissement correspondant au début des palmes. En effet, le point d'élargissement correspondant au début des palmes constitue une zone de contraintes maximales en cas de chocs. Dans ces conditions, grâce aux caractéristiques de la présente invention, l'extrémité fragile de la rainure se trouve à une certaine distance de la zone de contraintes maximales en cas de chocs. De plus, le fait que les rainures s'étendent jusqu'au-delà du début des palmes permet d'augmenter la capacité motionelle du résonateur en répartissant mieux les contraintes associées à la vibration, et à la masse des palmes.

Selon un mode de réalisation avantageux de la présente invention, les rainures ont leur point de départ à l'intérieur de la base 4 en deçà de la zone d'ancrage des bras.

D'autre part, selon un autre mode de réalisation avantageux de la présente invention, la longueur de la base est comprise entre 4.5 et 6.5 fois la largeur moyenne d'un bras vibrant. Des expériences menées par le déposant ont en effet montré que la non observation de cette relation peut conduire à des effets de sensibilité au montage, ainsi qu'à des instabilités de fréquence et/ou de résistance équivalente. En effet, même en cas de miniaturisation extrême, il est nécessaire de ménager des surfaces de connections, dont la dimension est tributaire de la technologie de fixation. Il est également nécessaire de garantir une distance minimale entre la zone de fixation et la zone élastiquement active du résonateur, en vue d'avoir un découplage mécanique aussi efficace que possible.

De préférence, la longueur de la base correspond approximativement à 6 fois la largeur moyenne d'un bras vibrant.

Dans le cadre de la présente invention plusieurs expériences avec des profondeurs de rainures différentes ont montré que la capacité motionnelle du résonateur est bien plus sensible lorsque la rainure est profonde. Ainsi, pour une profondeur de rainure comprise entre 40 et 50% de l'épaisseur du bras vibrant, le résonateur présente une capacité motionnelle pour la fréquence fondamentale trop sensible aux tolérances de fabrication et une fragilité trop importante de toute sa structure. Une profondeur desdites rainures d'au plus de 40% de l'épaisseur des bras vibrants est donc préférable puisqu'elle présente un bon compromis entre les dimensions du résonateur et sa résistance aux contraintes mécaniques.

Bien qu'une épaisseur de rainure comprise entre 30 et 40% de l'épaisseur du bras vibrant présente certains avantages, un bras avec une telle épaisseur peut demeurer insuffisamment résistant aux contraintes mécaniques et pour plus de sécurité, une profondeur desdites rainures correspondant au plus à 30% de l'épaisseur des bras vibrants semble encore préférable.

D'autre part, d'une manière avantageuse, les palmes sont lestées afin de pouvoir ajuster facilement la fréquence fondamentale.

Les rainures peuvent être, soit de forme rectangulaire pour réduire l'espace entre les électrodes et ainsi augmenter davantage la première capacité motionnelle, soit d'une forme effilée s'adaptant à la forme des bras pour éviter les courts-circuits entre les électrodes.

### BREVE DESCRIPTION DES DESSINS

D'autres caractéristiques et avantages de l'invention apparaîtront à la lecture de la description qui suit en liaison avec les dessins annexés dans lesquels :
- la figure 1 représente un résonateur à diapason selon un mode de réalisation particulier de la présente invention ;
- la figure 1a représente une coupe selon la ligne A-A de la figure 1 ;
- la figure 2 est un graphique représentant le taux de pièces cassées au niveau de la palme en fonction de la position de l'extrémité de la rainure par rapport au début des palmes.
- la figure 3 est un graphique représentant la résistance équivalente en fonction de la longueur de la rainure pour un rapport de longueur à laquelle commence la palme de 67%.

### DESCRIPTION DETAILLEE DE L'INVENTION

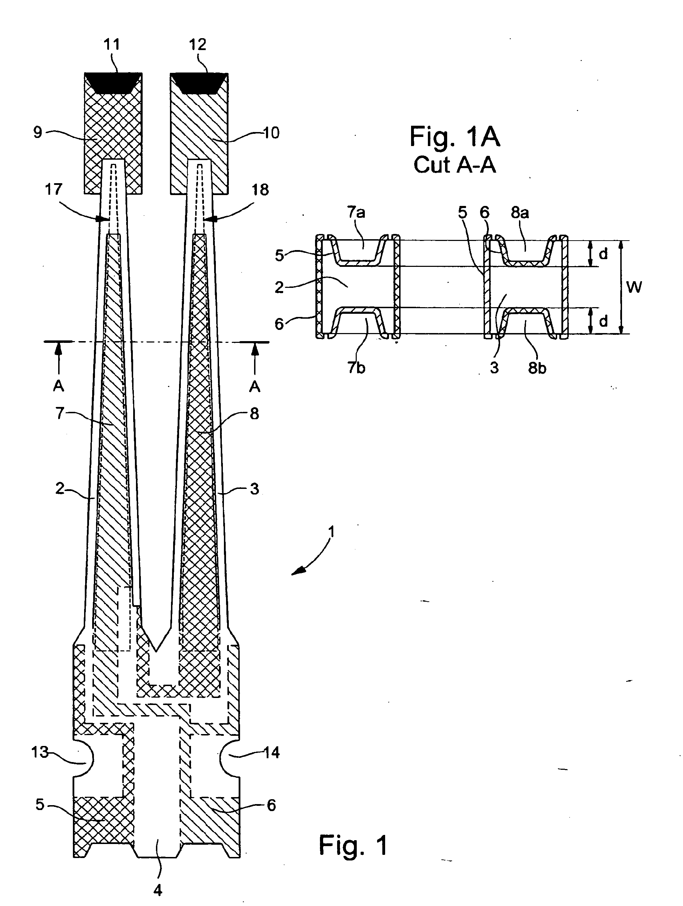

L'invention sera décrite ci-après en liaison avec un exemple non limitatif donné en référence aux les figures 1 à 3.

Dans le mode de réalisation particulier qui est représenté à la figure 1, le résonateur désigné par la référence 1 comprend une pièce en forme de diapason comprenant deux bras vibrants 2 et 3 réunis par une base 4, l'ensemble étant réalisé en une seule pièce en un matériau piézo-électrique, tel que le quartz. La base 4 et les bras 2 et 3 portent des métallisations, c'est-à-dire des dépôts conducteurs, qui forment un jeu d'électrodes 5 et 6 qui permettant aux bras d'être soumis à des champs électriques pour les faire vibrer à une fréquence désirée, dite fréquence fondamentale. Les métallisations formées sur les bras constituent des électrodes centrales sur les surfaces principales opposées et des électrodes latérales le long des côtés de chaque bras. Des rainures 7 et 8 sont encore formées dans au moins une des faces avant ou arrière de chaque bras vibrant. On peut voire sur la figure que ces rainures 7 et 8 commencent à l'intérieur de la base 4 et s'étendent le long des bras jusque sensiblement au-delà du point d'élargissement correspondant au début des palmes 9 et 10. En modifiant ainsi la section du bras sur pratiquement toute sa longueur, ces rainures permettent d'obtenir des performances plus précises, même lorsque le dispositif est miniaturisé.

On voit encore sur la figure 1 que les électrodes centrales de chaque bras sont formées à l'intérieur des rainures 7, 8. Un avantage d'une telle disposition des électrodes centrales à l'intérieur des rainures, dans l'épaisseur des bras, est qu'elle augmente le couplage piézo-électrique.

On peut voire sur la figure 1 que l'épaisseur des bras vibrants 2 et 3 va en diminuant sur un tronçon qui représente la majeure partie de la longueur de ceux-ci. Le fait que les bras vibrant comprennent un tronçon principal de forme effilée présente l'avantage de mieux répartir les tensions dans le cristal et ainsi d'augmenter la capacité motionnelle pour la fréquence fondamentale, tout en diminuant la capacité motionnelle pour la fréquence partielle. On voit encore que la partie effilée de chaque bras vibrant est coiffée d'une palme plus large (référencées respectivement 9 et 10). Ces palmes formant l'extrémité des bras vibrants 2 et 3 permettent de réduire encore davantage les dimensions des bras 2 et 3 sans modifier les caractéristiques du résonateur et tout en assurant une meilleure distribution des contraintes mécaniques le long des bras. De manière avantageuse, une masse de balourd 11 et 12 peut encore être ajoutée aux palmes 9 et 10, de manière à obtenir un meilleur ajustement de la fréquence fondamentale du résonateur.

D'autre part, la figure 1 montre également que dans le présent exemple, les électrodes centrales s'arrêtent avant le début des palmes 9 et 10 et donc aussi largement avant l'extrémité distale des rainures 7 et 8. Un avantage d'un tel agencement est de ne pas dépenser d'énergie électrique dans une zone où la capacité motionnelle est fortement réduite en raison de la rigidité relative des palmes 9 et 10.

Enfin, dans le présent mode de réalisation particulier, des encoches 13 et 14 ont encore été prévues dans la portion de base 4 pour améliorer le découplage mécanique entre les bras vibrants et la partie fixe de la base.

De préférence, la largeur w1 du bras à l'extrémité distale du tronçon de forme effilée (au niveau du point d'élargissement correspondant au début des palmes) est choisie pour être comprise entre 30 et 60% de la largeur w2 du bras à l'extrémité proximale du tronçon de forme effilée (au niveau de la jonction avec la base 4 du résonateur). De manière avantageuse, un meilleur compromis est obtenu pour un rapport entre les deux largeurs susmentionnées w1 et w2 compris entre 45 et 55%.

D'autre part, la largeur de la palme est préférablement comprise entre 1.5 et 2.5 fois la largeur moyenne du tronçon de forme effilée du bras.

Considérons maintenant la figure 1a qui est une coupe de la figure 1 le long de la ligne A-A qui représente les deux bras vibrants 2 et 3 dans lesquels les rainures 7a, 7b, 8a et 8b sont formées le long de la direction longitudinale du résonateur à diapason. Selon une variante, chaque bras pourrait ne présenter qu'une seule rainure sur sa face frontale ou sur sa face arrière. D'une part, pour assurer une résistance mécanique suffisante de la structure du résonateur, les rainures devraient être aussi peu profondes que possible. D'autre part, ces rainures devraient par contre être aussi profondes que possible, soit pour assurer une meilleure résistance équivalente pour un facteur de qualité donné, soit pour réduire les dimensions du résonateur pour une résistance équivalente recherchée. Le meilleur compromis devrait être recherché en prenant en compte la forme effilée des bras vibrants.

Dans le cadre de la présente invention il a été montré que la profondeur d'une rainure est de préférence inférieure à 40% de l'épaisseur w des bras vibrants, et qu'une telle profondeur permet d'obtenir un bon compromis entre le dimensions du résonateur et sa résistance aux contraintes mécaniques. Bien qu'une profondeur de rainure comprise entre 30 et 40% de l'épaisseur d'un bras vibrant présente certains avantages, pour plus de sécurité un compromis optimisé entre les dimensions du résonateur et sa résistance aux contraintes mécaniques est obtenu pour une profondeur de rainure d inférieure à 30% de l'épaisseur w des bras vibrants.

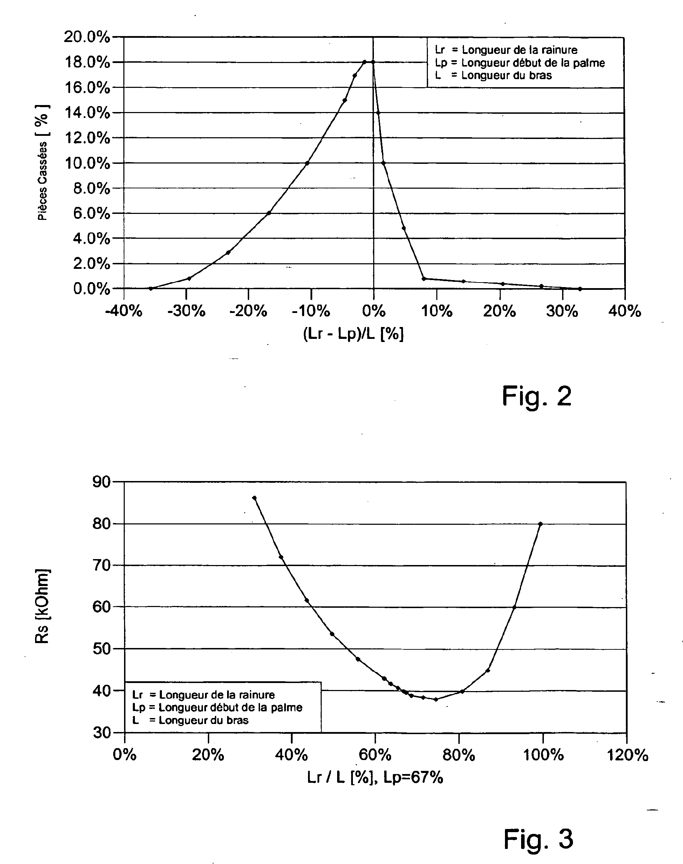

La figure 2 est un graphique indiquant le pourcentage de pièces cassées lors de chocs en fonction de la position de l'extrémité de la rainure. Sur ce graphique, Lr est la longueur jusqu'à l'extrémité de la rainure, Lp est la longueur à laquelle commence la palme, et L est la longueur du bras. Ces trois longueurs sont mesurées à partir de l'ancrage du bras dans la base.

Comme on peut le voir sur la figure, la géométrie des rainures formées dans les bras vibrants est déterminante en ce qui concerne la résistance au choc de l'oscillateur. En effet, le graphique indique que le taux de casse est beaucoup plus élevé lorsque l'extrémité distale de la rainure coïncide avec le point d'élargissement correspondant au début des palmes (Lp = Lr ; abscisse 0% sur le graphique). Un facteur déterminant pour expliquer ce phénomène réside certainement dans l'effet de la masse considérable que constituent ces palmes. Un autre facteur à prendre en considération réside probablement dans le fait que les rainures sont gravées par attaque chimique du cristal de quartz. De manière connue, l'attaque chimique a tendance à révéler de multiples plans cristallins, en particulier au niveau des extrémités des rainures. Cette démultiplication des facettes cristallines présente l'inconvénient d'entraîner une plus grande sensibilité aux chocs, ainsi qu'aux contraintes qui leurs sont associées.

Quelle que soit la cause du phénomène, il semble avantageux de positionner les extrémités des rainures en dehors des zones de contraintes maximales associées aux chocs. Pour ce faire, Il y a a priori deux solutions. La première est de placer l'extrémité des rainures en deçà des palmes, ou pour être plus précis nettement en deçà du point d'élargissement des bras. La seconde possibilité, qui fait l'objet de la présente invention, est de placer l'extrémité des rainures nettement au-delà du point d'élargissement des bras, de façon à ce que la zone de contraintes maximales associée aux chocs se répartisse sur les parois latérales des rainures.

La figure 3 est un graphique qui donne la résistance équivalente en fonction de la longueur de la rainure dans le cas particulier où, sur chaque bras vibrant, le point d'élargissement correspondant au début d'une palme est situé à 67% de la longueur du bras (Lp / L = 67%). On observe sur la figure 3 que la résistance équivalente présente un minimum qui est situé non loin de l'abscisse 67%, c'est-à-dire proche de la situation où l'extrémité distale de la rainure coïncide avec le début des palmes (Lp = Lr). De plus, lorsque l'extrémité distale de la rainure se trouve plus loin, pratiquement à l'extrémité d'un bras, la résistance équivalente remonte en raison de l'altération des propriétés mécaniques de la palme.

Un examen plus attentif du graphique montre toutefois que la résistance équivalente est plus faible lorsque la rainure s'étant un peu au-delà du début de la palme que lorsque la rainure s'arrête un peu en deçà du début de la palme. Selon la présente invention, la rainure s'étant donc sensiblement au-delà du début de la palme de manière à minimiser simultanément le taux de pièces cassées (figure 2) et la résistance équivalente (figure 3). Un autre avantage de cet agencement conforme à la présente invention est qu'il permet d'augmenter la capacité motionelle du résonateur en répartissant mieux les contraintes associées à la vibration, et à la masse des palmes.

De préférence, la distance sur laquelle s'étend une rainure au-delà du début de la palme est comprise entre une et deux fois la largeur moyenne du bras. De plus, cette distance est avantageusement d'au moins trois fois la profondeur des rainures. Toutefois, l'extrémité des rainures est de préférence plus proche du début des palmes que de l'extrémité des bras. Cet agencement permet d'éviter tout à la fois une élévation de la résistance équivalente et l'activation d'autres modes de vibrations.

Bien que l'invention ait été décrite en liaison avec un certain mode de réalisation spécifique, on comprendra que ce mode de réalisation ne constitue pas une limitation de l'invention. En effet, diverses modifications adaptations et/ou combinaisons de caractéristiques apparaîtront à l'homme du métier sans sortir du cadre de l'invention, qui est défini par les revendications annexées. Par exemple, la forme effilée des électrodes représentées sur la figure 1 peut être remplacée par une forme rectangulaire. Dans ce cas, les électrodes de forme rectangulaire réduisent l'espace entre les électrodes et augmentent ainsi la capacité motionnelle du mode fondamental d'oscillation.

## Revendications

1. Résonateur piézo-électrique à diapason (1) comprenant une base (4) à partir de laquelle s'étendent des premier et second bras vibrants parallèles (2, 3) se prolongeant chacun par une portion élargie en forme de palme (9, 10) constituant l'extrémité libre de chaque bras, chacun desdits bras vibrant portant un jeu d'électrodes d'excitation (5, 6) pour les faire vibrer à une fréquence fondamentale, ledit jeu d'électrodes d'excitation (5, 6) comportant des électrodes centrales sur les surfaces principales opposées desdits bras et des électrodes latérales le long des côtés desdits bras, et comprenant en outre au moins une rainure (7, 8) formée sur au moins une des faces supérieures ou inférieures de chacun desdits bras, ladite rainure (7, 8) se prolongeant en direction de l'extrémité libre d'un bras jusqu'au delà du début de la palme (9, 10), **caractérisé en ce que** lesdits bras vibrants présentent une forme généralement effilée, et **en ce que** lesdites électrodes centrales ne s'étendent pas jusqu'au début des palmes (9, 10) mais s'arrêtent avant.

2. Résonateur piézo-électrique à diapason selon la revendication 1, **caractérisé en ce que** ladite rainure (7, 8) formée sur chacun desdits bras (2, 3) a son point de départ l'intérieur de la base (4), en deçà d'une zone d'ancrage des bras.

3. Résonateur piézo-électrique à diapason selon la revendication 1 ou 2, **caractérisé en ce que** la distance sur laquelle s'étend la rainure (7, 8) au-delà du début de la palme est comprise entre une et deux fois la largeur moyenne du bras (2, 3).

4. Résonateur piézo-électrique à diapason selon l'une des revendications 1, 2 ou 3, **caractérisé en ce que** la distance sur laquelle s'étend la rainure (7, 8) au-delà du début de la palme est d'au moins trois fois la profondeur de la rainure.

5. Résonateur piézo-électrique à diapason selon l'une des revendications précédentes, **caractérisé en ce que** l'extrémité de la rainure (7, 8) est plus proche du début de la palme (9, 10) que de l'extrémité de celle-ci.

6. Résonateur piézo-électrique à diapason selon l'une des revendications précédentes, **caractérisé en ce que** la profondeur desdites rainures est inférieure à 40% de l'épaisseur des bras vibrants afin d'obtenir un bon compromis entre les dimensions du résonateur et la résistance aux contraintes mécaniques de ce dernier.

7. Résonateur piézo-électrique à diapason selon la revendication 6, **caractérisé en ce que** la profondeur desdites rainures (7, 8) est inférieure à 30% de l'épaisseur des bras vibrants (2, 3) afin d'obtenir un compromis optimisé entre les dimensions du résonateur et la résistance aux contraintes mécaniques de ce dernier.

8. Résonateur piézo-électrique à diapason selon l'une quelconque des revendications précédentes, **caractérisé en ce que** lesdites rainures (7, 8) présentent une forme rectangulaire pour réduire l'espace entre les électrodes et augmenter davantage la première capacité motionnelle.

9. Résonateur piézo-électrique à diapason selon l'une quelconque des revendications précédentes, **caractérisé en ce que** lesdites rainures (7, 8) présentent une forme effilée pour empêcher les courts-circuits entre les électrodes.

## Claims

1. Piezoelectric tuning fork resonator (1) including a base (4) from which first and second parallel vibrating arms (2, 3) extend, each extended by an enlarged portion in the shape of a flipper (9, 10) forming the free end of each arm, each of said vibrating arms carrying a set of excitation electrodes (5, 6) for vibrating the arms at a fundamental frequency, said set of excitation electrodes (5, 6) including central electrodes on the main opposite surfaces of said arms and lateral electrodes along the sides of said arms, and further including at least one groove (7, 8) formed on at least one of the top or bottom surfaces of each of said arms, said groove (7, 8) extending in the direction of the free end of an arm to beyond the start of the flipper (9,10), **characterized in that** said vibrating arms have a generally tapered shape, and **in that** said central electrodes do not extend to the start of the flippers (9, 10), but stop before.

2. Piezoelectric tuning fork resonator according to claim 1, **characterized in that** the starting point of said groove (7, 8) formed on each of said arms (2, 3) is inside the base (4), before an arm anchorage zone.

3. Piezoelectric tuning fork resonator according to claim 1 or 2, **characterized in that** the distance over which the groove (7, 8) extends beyond the start of the flipper is comprised between one or two times the mean width of the arm (2, 3).

4. Piezoelectric tuning fork resonator according to any of claims 1, 2 or 3, **characterized in that** the distance over which the groove (7, 8) extends beyond the start of the flipper is at least three times the depth of the groove.

5. Piezoelectric tuning fork resonator according to any of the preceding claims, **characterized in that** the end of the groove (7, 8) is closer to the start of the flipper (9, 10) than to the end thereof.

6. Piezoelectric tuning fork resonator according to any of the preceding claims, **characterized in that** the depth of said grooves is less than 40% of the thickness of the vibrating arms in order to obtain a good compromise between the dimensions of the resonator and the resistance to mechanical stress thereof.

7. Piezoelectric tuning fork resonator according to claim 6, **characterized in that** the depth of said grooves (7, 8) is less than 30% of the thickness of the vibrating arms (2, 3) in order to obtain an optimised compromise between the dimensions of the resonator and the resistance to mechanical stress thereof.

8. Piezoelectric tuning fork resonator according to any of the preceding claims, **characterized in that** said grooves (7, 8) have a rectangular shape in order to reduce the space between the electrodes and further increase the first motional capacitance.

9. Piezoelectric tuning fork resonator according to any of the preceding claims, **characterized in that** said grooves (7, 8) have a tapered shape in order to prevent short circuits between the electrodes.

## Patentansprüche

1. Piezoelektrischer Stimmgabelresonator umfassend eine Basis (4), von welcher sich erste und zweite parallele Vibrationsarme (2, 3) über einen erweiterten palmenartigen Abschnitt (9, 10), der das freie Ende eines jeden Arms bildet, erstrecken, wobei jeder der Vibrationsarme einen Satz Anregungselektroden (5, 6) aufweist, um die Arme bei einer Basisfrequenz in Vibration zu versetzen, wobei der Satz Anregungselektroden (5, 6) auf den gegenüberliegenden Hauptflächen der Arme Zentralelektroden sowie Lateralelektroden entlang der Seiten der Arme aufweisen, und wobei unter anderem zumindest eine zumindest an den Oberseiten oder Unterseiten eines jeden Armes ausgebildete Rille (7, 8) vorgesehen ist, wobei sich die Rille (7, 8) in Richtung des freien Endes des Arms bis zum Beginn der Palme (9, 10) erstreckt, **dadurch gekennzeichnet, dass** die Vibrationsarme eine im Wesentlichen zugespitzte Form aufweisen und dass die Zentralelektroden sich nicht bis zum Beginn der Palmen (9, 10) erstrecken, sondern davor enden.

2. Piezoelektrischer Stimmgabelresonator nach Anspruch 1, **dadurch gekennzeichnet, dass** die auf jedem der besagten Arme (2, 3) ausgebildete Rille (7, 8) einen innerhalb der Basis (4) liegenden Ausgangspunkt unterhalb einer Verankerungszone der Arme hat.

3. Piezoelektrischer Stimmgabelresonator nach Anspruch 1 oder 2, **dadurch gekennzeichnet, dass** der Abstand, bis zu welchem sich die Rille (7, 8) unterhalb des Beginns der Palme erstreckt zwischen der einfachen und zweifachen durchschnittlichen Breite des Arms (2, 3) liegt.

4. Piezoelektrischer Stimmgabelresonator nach einem der vorhergehenden Ansprüche 1, 2 oder 3, **dadurch gekennzeichnet, dass** der Abstand, bis zu welchem sich die Rille (7, 8) bis zum Beginn der Palme erstreckt, wenigstens das Dreifache der Tiefe der Rille ist.

5. Piezoelektrischer Stimmgabelresonator nach einem der vorhergehenden Ansprüche, **dadurch gekennzeichnet, dass** das Ende der Rille (7, 8) näher am Beginn der Palme (9, 10) liegt, als an deren Endabschnitt.

6. Piezoelektrischer Stimmgabelresonator nach einem der vorhergehenden Ansprüche, **dadurch gekennzeichnet, dass** die Tiefe der Rillen weniger als 40 % der Dicke der Vibrationsarme beträgt, um einen guten Kompromiss zwischen den Abmessungen des Resonators und deren mechanischem Widerstand zu erhalten.

7. Piezoelektrischer Stimmgabelresonator nach Anspruch 6, **dadurch gekennzeichnet, dass** die Tiefe der besagten Rillen (7, 8) weniger als 30 % der Dicke der Vibrationsarme (2, 3) beträgt, um einen optimalen Kompromiss zwischen den Abmessungen des Resonators und dessen mechanischem Widerstand zu erhalten.

8. Piezoelektrischer Stimmgabelresonator nach einem beliebigen der hervorgehenden Ansprüche, **dadurch gekennzeichnet, dass** besagte Rillen (7, 8) eine rechteckige Form darstellen, um den Zwischenraum zwischen den Elektroden zu verringern und um die erste Bewegungskapazität zu erhöhen.

9. Piezoelektrischer Stimmgabelresonator nach einem beliebigen der hervorgehenden Ansprüche, **dadurch gekennzeichnet, dass** die besagten Rillen (7, 8) eine zugespitzte Form aufweisen, um Kurzschlüsse zwischen den Elektroden zu unterbinden.
